# EUROPEAN PATENT SPECIFICATION

(11) **EP 0 962 979 B1**
(45) Date of publication and mention of the grant of the patent: **12.03.2003**
(21) Application number: 99110606.3
(22) Date of filing: 02.06.1999
(51) Int. Cl.: H01L 23/544

(54) **Programmable electronic circuit with an identification number and external connections for control, actuation and display**
Programmierbare elektronische Schaltung mit Identifikationsnummer und Aussenanschlüssen für Steuerung, Betätigung und Anzeigen
Circuit électronique programmable avec numéro d'identification et connexions extérieures à commande, à l'actionnement et à l'affichage

(30) Priority: 03.06.1998 IT MI981244
(43) Date of publication of application: 08.12.1999
(73) Proprietor: Ancona, Lorenzo, 20100 Milan (IT); Ancona, Cristiano, 20100 Milan (IT)
(72) Inventor: Ancona, Lorenzo, 20100 Milan (IT); Ancona, Cristiano, 20100 Milan (IT)
(74) Representative: Coloberti, Luigi

(56) References cited:
- US-A- 4 488 148
- US-A- 5 229 649
- US-A- 5 276 692
- US-A- 5 543 761
- US-A- 5 686 759

## Description

### BACKGROUND TO THE INVENTION

The present invention relates to a computerised monolithic circuit CMC module which can be connected to electrical control devices such as for example push-buttons and/or switches, and to display devices for providing information on a performed command (micro lights), or to electromechanical or static relays, having functions which can be programmed and reprogrammed both locally and by remote control. The circuit can be fitted with an AWG26 three-lead cable for civil and industrial electrical systems with very low voltage (SELV - security extra low voltage), with which it is possible to introduce new levels of operations, practical use and management of an electrical system, not attainable with conventional systems engineering.

The module according to the invention, in addition to introducing new levels of operations, practical use and management of an electrical system, also enables combined use with standard electrical components.

The module according to the present invention is particularly suitable for use in the refurbishment of rooms or in the design of buildings via traditional prefabrication techniques. It also allows a considerable reduction in masonry work, hitherto essential for installing an electrical plant or, in the refurbishment of rooms, it enables existing masonry to be reused, with standard embedded boxes and relevant electrical products, in order to perform a higher number of command and/or actuation functions, programmable in various ways, according to needs, by laying down only three wires.

The module according to the present invention is made completely watertight by a casing in epoxy resin or in a thermosetting material, thus suitable for use also in damp areas or outside. Moreover, as referred previously, it can be connected to electrical control devices such as push-buttons and/or switches and devices for displaying a performed command (micro lights), also of a standard type, housed in standard embedded boxes, and to an infrared or black light detection cell for remote control of its command devices.

The functions of electrical devices for command or actuation, via memories (EEPROM) contained in a microprocessor, can be programmed and reprogrammed both locally and by remote control, either for a high number of addressings to actuation devices or for changing the functions of each of their individual command or actuation devices, according to the requirements of use.

All the CMC circuit modules forming an integral part of an electrical system are connectable in parallel by means of three wires, two of which are used for their low voltage power supply, and the third for data receiving and data transmitting operations.

Programming and reprogramming of the transmitting functions of each individual command (TX) or receiving functions of each individual actuation (RX), can be performed by remote control either with a simple programming device of switch type which can be connected by the same three wires to the CMC circuits, or via an interface by means of a personal computer, or locally by means of electrical jumpers.

The CMC circuit modules according to the present invention can be manufactured either by the printed circuit technique, with standard components or SMD, or by the thick film technique, or again by integrated circuits, being particularly suitable for civil and industrial electrical systems with controls at very low voltage (SELV - security extra low voltage).

An unlimited number of modules programmed with command functions (TX) can be connected in parallel one to the other, and up to 256 CMC circuits can be programmed for actuation functions (RX) of 8 relays, for an overall total of 2048 accuations and/or functions, depending on the microprocessor used for the same CMC circuit.

US 5.686.759, US 4.488.148, US 5.229.649 represent the closest prior art to the present invention.

### BRIEF DESCRIPTION OF THE INVENTION

According to the invention, a computerised monolithic watertight electric circuit (CMC) module, has been provided, suitable for performing control or actuation functions for civil or industrial electrical systems, said module comprising:
- a watertight casing of substantially flat shape;
- a microprocessor having a programmable and an erasable memory comprising a plurality of inputs and outputs, said microprocessor memory being selectively programmable with command functions or actuation functions;
- a plurality of electric terminals for connection to electric command and actuation devices, arranged along the peripheral edge of the casing and operatively connected to the inputs and outputs of the microprocessor;
- means for the composition and storage into the microprocessor of an identification serial number of the circuit (CMC);
- said module also comprising three additional terminals connected to a three-lead cable, two of the leads supplying power to the electrical components in the module, the remaining lead acting to receive or transmit data by connecting the module in parallel to a second similar module or to a programming device.

According to a further aspect of the invention, the module can be provided with a pair of electric terminals for connection to an infrared or black light detection cell for remote control of its electrical command devices.

The module according to the invention can have any flat configuration; it is preferably of a rectangular shape having dimensions which vary according to the number of wires or terminals, with a relatively small size, for example a length of between 25 and 60 mm, a width of between 15 and 35 mm, and an extremely small thickness of between 4 and 15 mm which provide the CMC circuit with extremely small overall dimensions.

The module according to the invention can therefore be housed into boxes embedded of an electrical system connected to standard electrical control/actuation devices, if it is of the type having rigid terminals or wires or, if it is of the integrated circuit type, mounted directly on a base on board of the actuation devices.

### BRIEF DESCRIPTION OF THE DRAWINGS

These and further characteristics of the module, according to the invention, will be made clearer from the following description with reference to the accompanying drawings, in which:
Fig. 1 is a perspective view of a CMC circuit according to the invention, made by the printed circuit or thick film technique, with the lower dotted part embedded in resin and with rigid connectors which can be replaced with wires; the drawing schematically indicates some basic components totally embedded in a protective resin.
Fig. 2 is a perspective view of a module according to the invention, made by the printed circuit technique which can be mounted onto a base;
Fig. 3 shows the wiring diagram for the main components of the module of Figure 1 and Figure 2.

### DETAILED DESCRIPTION OF THE INVENTION

A description is now given of a first embodiment of a computerised monolithic circuit module according to the invention, hereinafter referred to more simply as "module". This representation is given purely by way of an explanation, without thereby forming a limitation as regards shape, dimensions and type of module, as well as the features of the various electrical control devices, such as for example push-buttons and/or switches, displaying devices for the performed commands (micro lights), or electrical actuation devices such as for example electromechanical or static relays which can be connected to the module.

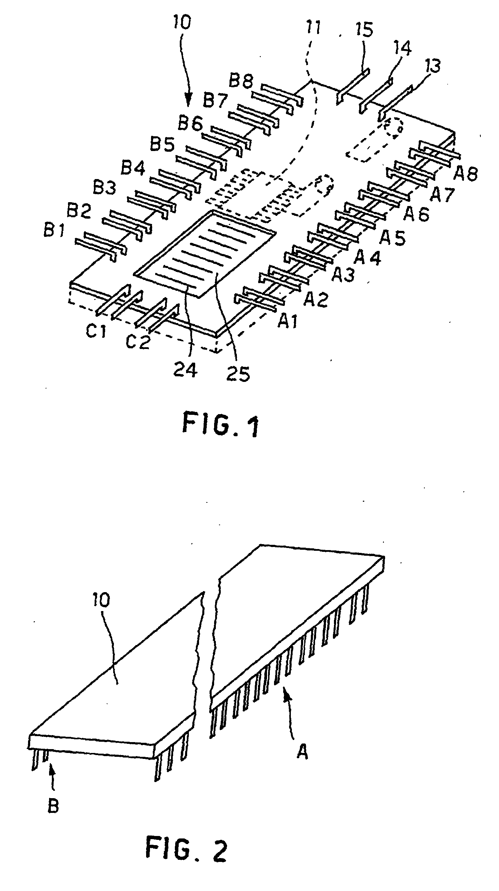

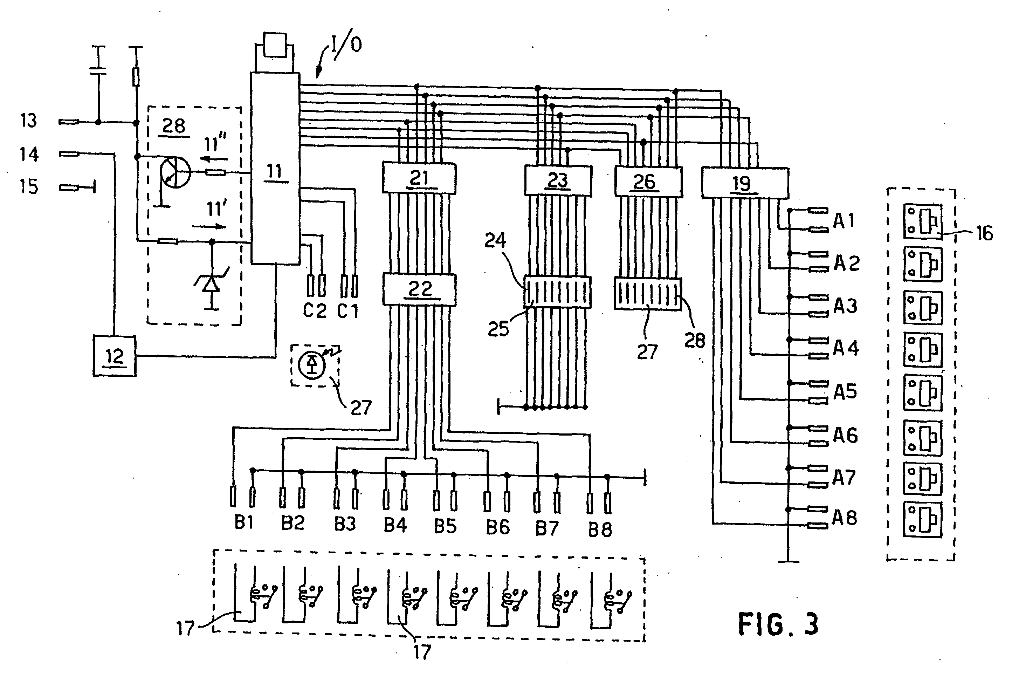

As shown in Figure 1, the module, denoted overall by 10, is substantially composed of a printed circuit of the standard type or of thick film technique, formed with the necessary connection tracks for the various electrical components, according to the example of Figure 3.

More specifically, as the three figures show, in the case in consideration the module 10 comprises a microprocessor 11, for example a 68HC8C5K3 microprocessor produced by Motorola and provided with memories (EEPROM) which can be electrically erasable and repeatedly programmable with two operating modes: a first command one (TX) and a second actuation one (RX), which can be selected via a pair of connectors C1 to provide 2048 modes of addressing, 6 relay operating modes (monostable, stepped, set/reset, timer, switch and inverter) and 256 modes for programming an identification number of the same module.

This latter case is only for modules made by the integrated circuits and thick film technology. In particular, in the example shown, the serial output 11' and 11" of the microprocessor 11, as well as a power supply unit 12, are connected by means of an appropriate interface 28 to three terminals 13, 14 and 15 (alternatively to three prewired cables) for supplying power to the module and respectively for receiving and transmitting function signals and/or of programming data.

From the same figures it can also be seen that the I/O of the microprocessor 11 are connected to two sets of double terminals (alternatively thirty-two prewired cables), denoted overall by A1 to A8 and B1 to B8, arranged along the edges of the printed circuit. Each pair of terminals A can be connected to corresponding control devices (push-buttons/switches) 16, while each pair of terminals B can be connected to corresponding display devices for providing information on a performed command (micro light) if the CMC is set up with command functions (TX), while if it is set up with an actuation function (RX), only the pairs of terminals B are enabled for actuation of corresponding electromechanical or static relays 17. Enabling of actuation (RX) or (TX) is performed by means of the pair of terminals C1.

More specifically, in the example of Figure 3, the I/O of the microprocessor 11, programmed with a command operating mode (TX), are connected, via a multiplexer 19, to the group of terminals A1-A8 connected in turn, via appropriate connectors (not shown), to 8 electrical control devices 16, outside the module or forming part of an electrical system, for example housed in a standard embedded box.

The same inlets/outlets (I/O) of the microprocessor 11, again programmed or set up for operating in TX mode (command), are connected, via a multiplexer 21 and an interface 22, to the group of terminals B1-B8, in turn connected, via appropriate connectors (not shown) to 8 electrical devices for displaying the command performed, outside of the module 10, for example housed in the same actuation devices (push-buttons/switches) or otherwise positioned.

The same I/O of the microprocessor 11 programmed or set up instead for operating in RX mode (actuation), again connected via the multiplexer 21 and the interface 22 to the group of terminals B1-B8, can in turn be connected via connectors (not shown) to 8 external relays 17, of electromechanical or static type and variously arranged and/or connected in a civil or industrial electrical system.

Finally, in the example of Figure 3, it can be seen that the I/O of the microprocessor 11 are connected, via a multiplexer 23, to eight interruptable tracks 24, for assigning to the module 10 a serial number of identification which is stored in a memory area of the microprocessor.

The identification number is programmed, in the case of a module made by the printed or thick film technique, by cutting one or more of the eight tracks 24 contained within the square 25 on the rear part of a flat casing of the module 10.

Since the computerised circuit according to the invention can be made by any technology, for example by the technology of printed circuits or thick film according to the example illustrated, or by the technology of integrated circuits, in the latter case the outputs of the multiplexer 23 are provided on the eight connectors of the module made by the integrated circuit technology, and represented by way of an example in Figure 2.

In an alternative form, the individual terminals can be in the form of electrical wires which can be connected directly or indirectly to the electrical controls, relays and/or display device.

The module with programmable functions, made in this way, has extremely small dimensions, thus enabling the housing in standard embedded boxes for electrical fittings or the like, and which can be reduced further if made by the thick film or integrated technologies. Purely by way of a non-limiting example, a circuit of the type described can have dimensions of 25 x 60 x 4 mm approximately, or smaller or larger ones, according to the number of terminals of each group. The same terminals can be formed and/or positioned differently in relation to what shown.

Again with reference to the example of Figure 3, the microprocessor 11 can be connected to a pair of terminals C2 for an infrared or black light detection cell 27 suitable for receiving remote commands for performing the functions of the various electrical command devices.

Finally 27 in Figure 3 denotes a device for local programming of the microprocessor 11, of the jumper type 28, connected to the I/O of the microprocessor via a multiplexer device 26 for example of the type having eight tracks, or of another suitable type.

The intent in any case is that what has been said and shown with reference to the accompanying drawings has been given purely by way of a non-limiting example of the CMC module with programmable functions according to the invention, and that other changes or variants can be made without departing from the scope of the annexed claims.

## Claims

1. Computerised monolithic watertight electric circuit (CMC) module, suitable for performing control or actuation functions for civil or industrial electrical systems, said module comprising:
- a watertight casing of substantially flat shape;
- a microprocessor (11), having a programmable and an erasable memory comprising a plurality of inputs and outputs, said microprocessor memory being selectively programmable with command functions or actuation functions ;
- a plurality of electric terminals (A1-A8; B1-B8; 13, 14, 15) for connection to electric command and actuation devices, arranged along the peripheral edge of the casing and operatively connected to the inputs and outputs of the microprocessor (11);
- means (24, 13) for the composition and storage into the microprocessor (11) of an identification serial number of the circuit (CMC);
- said module also comprising three additional terminals (13, 14, 15) connected to a three-lead cable, two of the leads supplying power to the electrical components in the module, the remaining lead acting to receive or transmit data by connecting the module in parallel to a second similar module or to a programming device.

2. Module according to claim 1, **characterised in that** said connection terminals (A1-A8; B1-B8; 13, 14, 15) are of the rigid type or prewired cables.

3. Module according to claim 1, **characterised by** comprising a further pair of terminals (C1, C2) for connection of the microprocessor (11) to a detection cell (27) for a remote control.

4. Module according to claims 1 to 3, **characterised in that** said module comprises a printed circuit.

5. Module according to claims 1 to 3, **characterised in that** said module comprises a thick film circuit.

6. Module according to claims 1 to 3, **characterised in that** said module is in the form of an integrated circuit.

7. Module according to claim 1, **characterised in that** it comprises a first set (A1-A8) and a second set (B1-B8) of double connection terminals, and **in that**, in the case wherein the microprocessor (11) is programmed and set for a command mode, said first set (A1-A8) of terminals are connected to external electrical control devices (16), and said second set (B1-B8) of terminals are connected to respective display devices for displaying the command performed by the same circuit.

8. Module according to claim 1, **characterised in that** it comprises a first set (A1-A8) and a second set (B1-B8) of double connection terminals, and **in that** in the case wherein the microprocessor (11) is programmed and set up with actuation mode (RX), at least one of said set of terminals is connected to external electrical actuation devices (17).

9. Module according to claim 8, **characterised in that** the electrical actuation devices (17) are mechanical or static relays, and **in that** the microprocessor (11) can be programmed and set up for individually providing different operating modes of the relays (17), included in the group: monostable, stepped, set/reset, timer, switch, inverter.

10. Module according to claim 3, wherein the module comprises printed circuit or thick film technology, **characterised in that** said composition means for the serial identification number comprises a set of interruptable tracks (24), connected to a respective input or output of the microprocessor (11).

11. Module according to claim 3, wherein the module comprises integrated circuit technology, **characterised in that** the means (25) for the composition of the serial identification number comprises a set of additional connectors, each connected to a respective input or output of the microprocessor (11) and connected to the earth according to a binary-code composition of the identification number.

12. Module according to claim 1, **characterised by** comprising a jumper circuit (27) for local programming of the microprocessor (11).

13. Module according to claim 1, **characterised by** comprising switch means or personal computer means for remote programming of the microprocessor (11).

14. Module according to claim 1, **characterised in that** said means for composition of the identification number for the circuit (CMC), comprises a programming device connected to the microprocessor (11) by the three-lead cable (13,14,15).

## Patentansprüche

1. Rechnergestütztes, monolithisches, wasserdichtes elektrisches Schaltungsmodul (CMC-Modul), das für die Ausführung von Steuerungs- oder Betätigungsfunktionen für bautechnische oder industrielle elektrische Systeme geeignet ist, wobei das Modul umfaßt:
- ein wasserdichtes Gehäuse mit im wesentlicher flacher Bauform;
- einen Mikroprozessor (11), der einen programmierbaren und löschbaren Speicher mit mehreren Eingängen und Ausgängen besitzt, wobei der Mikroprozessor-Speicher mit Befehlsfunktionen oder Betätigungsfunktionen wahlweise programmierbar ist;
- mebrere elektrische Anschlüsse (A1-A8; B1-B8; 13, 14, 15) für den Anschluß an elektrische Befehls- und Betätigungsvorrichtungen, die längs der Umfangskante des Gehäuses angeordnet und mit den Eingängen und Ausgängen des Mikroprozessors (11) funktional verbunden sind;
- Mittel (24, 13) für die Bildung und Speicherung einer Kennungsseriennummer der Schaltung (CMC) im Mikroprozessor (11);
- wobei das Modul ferner drei zusätzliche Anschlüsse (13, 14, 15) aufweist, die mit einem dreiadrigen Kabel verbunden sind, wobei zwei der Adern an die elektrischen Komponenten im Modul Leistung liefern und die verbleibende Ader dazu verwendet wird, Daten durch Parallelschaltung mit einem zweiten, ähnlichen Modul oder mit einer Programmierungsvorrichtung zu empfangen oder zu senden.

2. Modul nach Anspruch 1, **dadurch gekennzeichnet, daß** die Verbindungsanschlüsse (A1-A8; B1-B8; 13, 14, 15) vom starren Typ sind oder vorverdrahtete Kabel sind.

3. Modul nach Anspruch 1, **dadurch gekennzeichnet, daß** es ferner ein Paar Anschlüsse (C1, C2) für den Anschluß des Mikroprozessors (11) an eine Erfassungszelle (27) für eine Fernsteuerung umfaßt.

4. Modul nach den Ansprüchen 1 bis 3, **dadurch gekennzeichnet, daß** das Modul eine gedruckte Schaltung umfaßt.

5. Modul nach den Ansprüchen 1 bis 3, **dadurch gekennzeichnet, daß** das Modul eine Dickfilmschaltung umfaßt.

6. Modul nach den Anspruches 1 bis 3, **dadurch gekennzeichnet, daß** das Modul die Form einer integrierten Schaltung hat.

7. Modul nach Anspruch 1, **dadurch gekennzeichnet, daß** es eine erste Menge (A1-A8) und eine zweite Menge (B1-B8) von Doppelverbindungsanschlüssen besitzt und daß in dem Fall, in dem der Mikroprozessor (11) programmiert und für eine Befehlsbetriebsart eingestellt ist, die erste Menge (A1-A8) von Aaschlüssen mit externen elektrischen Steuervorrichtungen (16) verbunden ist und die zweite Menge (B1-B8) von Anschlüssen mit entsprechenden Anzeigevorrichtungen zum Anzeigen des von derselben Schaltung ausgeführten Befehls verbunden ist.

8. Modul nach Anspruch 1, **dadurch gekennzeichnet, daß** es eine erste Menge (A1-A8) und eine zweite Menge (B1-B8) von Doppelverbindungsanschlüssen umfaßt und daß in dem Fall, in dem der Mikroprozessor (11) programmiert ist und in eine Betätigungsbetriebsart (RX) eingestellt ist, wenigstens einer der Menge von Anschlüssen mit externen elektrischen Betätigungsvorrichtungen (17) verbunden ist.

9. Modul nach Anspruch 8, **dadurch gekennzeichnet, daß** die elektrischen Betätigungsvorrichtungen (17) mechanische oder statische Relais sind und daß der Mikroprozessor (11) so programmiert und eingestellt werden kann, daß er einzeln verschiedene Betriebsarten von Relais (17) bereitstellen kann, die in der folgenden Gruppe enthalten sind; monostabil, gestuft, Setzen/Rücksetzen, Zeitgeber, Schalter, Inverter.

10. Modul nach Anspruch 3, wobei das Modul eine Technologie gedruckter Schaltungen oder eine Dickfilm-Technologie aufweist, **dadurch gekennzeichnet, daß** die Mittel für die Bildung der Kennungsseriennummer eine Menge unterbrechbarer Bahnen (24) umfassen, die mit einem entsprechenden Eingang oder Ausgang des Mikroprozessors (11) verbunden sind.

11. Modul nach Anspruch 3, wobei das Modul eine Technologie integrierter Schaltungen aufweist, **dadurch gekennzeichnet, daß** die Mittel (25) zum Bilden der Kennungsseriennummer eine Menge zusätzlicher Verbinder umfaßt, wovon jeder entsprechend einem Binärcode-Aufbau der Kennungsnummer mit einem entsprechenden Eingang oder Ausgang des Mikroprozessors (11) und mit Erde verbunden ist

12. Modul nach Anspruch 1, **dadurch gekennzeichnet, daß** es eine Jumper-Schaltung (27) für die lokale Programmierung des Mikroprozessors (11) umfaßt.

13. Modul nach Anspruch 1, **gekennzeichnet durch** Schaltmittel oder Personalcomputer-Mittel für die Fernprogrammierung des Mikroprozessors (11).

14. Modul nach Anspruch 1, **dadurch gekennzeichnet, daß** die Mittel für die Bildung der Kennungsnummer der Schaltung (CMC) eine Programmiervorrichtung umfaßt, die mit dem Mikroprozessor (11) durch das dreiadrige Kabel (13, 14, 15) verbunden ist.

## Revendications

1. Module à circuit électrique monolithique informatisé étanche (CMC) adapté pour réaliser des fonctions de commande ou d'actionnement pour des systèmes électriques civils ou industriels, ledit module comprenant :
- un boîtier étanche de forme sensiblement plate,
- un microprocesseur (11) ayant une mémoire programmable et effaçable comprenant une pluralité d'entrées et de sorties, ladite mémoire de microprocesseur étant sélectivement programmable avec des fonctions de commande ou des fonctions d'actionnement,
- une pluralité de bornes électriques (A1-A8 ; B1-B8 ; 13, 14, 15) permettant la connexion à des dispositifs de commande électrique et d'actionnement, agencées le long du bord périphérique du boîtier et connectées de manière fonctionnelle aux entrées et sorties du microprocesseur (11) ;
- un moyen (24, 13) pour la composition et le stockage dans le microprocesseur (11) d'un numéro de série d'identification du circuit (CMC) ;
- ledit module comprenant en outre trois bornes supplémentaires (13, 14, 15) connectées à un câble à trois fils, deux des fils fournissant du courant aux composants électriques du module, le fil restant servant à recevoir ou transmettre des donnée en connectant le module en parallèle à un deuxième module similaire ou à un dispositif de programmation.

2. Module selon la revendication 1, **caractérisé en ce que** lesdites bornes de connexion (A1-A8 ; B1-B8 ; 13, 14, 15) sont de type rigide ou des câbles précâblés.

3. Module selon la revendication 1, **caractérisé en ce qu'**il comprend une paire supplémentaire de bornes (C1, C2) pour la connexion du microprocesseur (11) à une cellule de détection (27) pour une télécommande.

4. Module selon les revendications 1 à 3, **caractérisé en ce que** ledit module comprend un circuit imprimé.

5. Module selon les revendications 1 à 3, **caractérisé en ce que** ledit module comprend un circuit à couches épaisses.

6. Module selon les revendications 1 à 3, **caractérisé en ce que** ledit module se présente sous forme de circuit intégré.

7. Module selon la revendication 1, **caractérisé en ce qu'**il comprend un premier ensemble (A1-A8) et un deuxième ensemble (B1-B8) de bornes de connexion doubles, et **en ce que**, dans le cas où le microprocesseur (11) est programmé et configuré pour un mode commande, ledit premier ensemble (A1-A8) de bornes sont connectées à des dispositifs de commande électrique externes (16), et ledit deuxième ensemble (B1-B8) de bornes sont connectées à des dispositifs d'affichage respectifs pour afficher la commande exécutée par le même circuit.

8. Module selon la revendication 1, **caractérisé en ce qu'**il comprend un premier ensemble (A1-A8) et un deuxième ensemble (B1-B8) de bornes de connexion doubles, et **en ce que**, dans le cas où le microprocesseur (11) est programmé et configuré avec un mode d'actionnement (RX), au moins l'un desdits ensembles de bornes est connecté à des dispositifs d'actionnement électriques externes (17).

9. Module selon la revendication 8, **caractérisé en ce que** les dispositifs d'actionnement électriques (17) sont des relais mécaniques ou statiques, et **en ce que** le microprocesseur (11) peut être programmé et configuré pour fournir individuellement différents modes de fonctionnement des relais (17), compris dans le groupe : monostable, par paliers, RS, temporisateur, interrupteur, inverseur.

10. Module selon la revendication 3, dans lequel le module comprend une technologie de circuit imprimé ou à couches épaisses, **caractérisé en ce que** ledit moyen de composition pour le numéro d'identification de série comprend un ensemble de pistes aptes à être interrompues (24), connectées à une entrée ou sortie respective du microprocesseur (11).

11. Module selon la revendication 3, dans lequel le module comprend une technologie de circuit intégré, **caractérisé en ce que** le moyen (25) pour la composition du numéro d'identification de série comprend un ensemble de connecteurs supplémentaires, chacun connecté à une entrée ou sortie respective du microprocesseur (11) et connecté à la masse selon une composition en code binaire du numéro d'identification.

12. Module selon la revendication 1, **caractérisé en ce qu'**il comprend un circuit temporaire (27) pour la programmation locale du microprocesseur (11).

13. Module selon la revendication 1, **caractérisé en ce qu'**il comprend un moyen sous forme d'interrupteur ou d'ordinateur personnel pour la programmation à distance du microprocesseur (11).

14. Module selon la revendication 1, **caractérisé en ce que** ledit moyen pour la composition du numéro d'identification du circuit (CMC) comprend un dispositif de programmation connecté au microprocesseur (11) par le câble à trois fils (13, 14, 15).
